# EUROPEAN PATENT APPLICATION

(11) **EP 4 262 088 A1**
(43) Date of publication of application: **18.10.2023**
(21) Application number: 20967731.9
(22) Date of filing: 31.12.2020
(51) Int. Cl.: H03H 9/15, H03H 9/54

(54) **FILTER, AND METHOD FOR PREPARING FILTER**

(71) Applicant: Huawei Technologies Co., Ltd., Shenzhen, Guangdong 518129 (CN)
(72) Inventor: HOU, Hangtian, Shenzhen, Guangdong 518129 (CN); DU, Bo, Shenzhen, Guangdong 518129 (CN); LIU, Peng, Shenzhen, Guangdong 518129 (CN); GAO, Zongzhi, Shenzhen, Guangdong 518129 (CN)
(74) Representative: Gill Jennings & Every LLP
(86) International application number: PCT/CN2020/142085
(87) International publication number: WO 2022/141392

(57) **Abstract**

A filter (100) and a preparation method of the filter (100) are provided. The filter (100) includes: a substrate (10); a series resonator (20), where the series resonator (20) includes a first Bragg reflection layer (201) and a first piezoelectric transduction structure (202) that are sequentially stacked on the substrate (10); a parallel resonator (30), where the parallel resonator (30) includes a second Bragg reflection layer (301) and a second piezoelectric transduction structure (302) that are sequentially stacked on the substrate (10), and a structure of the first Bragg reflection layer (201) is different from a structure of the second Bragg reflection layer (301); a series branch (C), where the series branch (C) includes the series resonator (20), and the series branch (C) is coupled between an input end (Vi) of the filter and an output end (Vo) of the filter; and a parallel branch (P), where the parallel branch (P) includes the parallel resonator (30), and the parallel branch (P) is coupled between the series branch (C) and a common ground (Gnd). This structure can improve filter performance of the filter (100).

## Description

### TECHNICAL FIELD

Embodiments of this application relate to the field of filter technologies, and in particular, to a filter and a preparation method of a filter.

### BACKGROUND

With development of communication technologies, a demand for a radio frequency filter is increasing. When the filter is used in a scenario requiring high performance, for example, a 5G technology scenario, a filter formed by a film bulk acoustic resonator and an LC resonant circuit are usually combined to implement filtering of a radio frequency band.

In the conventional technology, when the filter formed by the film bulk acoustic resonator and the LC resonant circuit are combined and used in a high-performance technical scenario, the film bulk acoustic resonator in the filter usually needs to be disposed at an edge of a passband of a high-performance radio frequency band, to implement edge filtering of the passband of a 5G radio frequency band. In this case, a value of a quality factor (Q, quality factor) of the filter is low, and filtering effect of the filter is reduced. Therefore, when the filter formed by the film bulk acoustic resonator is used in the high-performance technical scenario, how to improve filtering performance of the filter becomes a problem that needs to be resolved.

### SUMMARY

This application provides a filter and a preparation method of a filter, which can improve performance of the filter.

To achieve the foregoing objectives, the following technical solutions are used in this application.

According to a first aspect, an embodiment of this application provides a filter, including: a substrate; a series resonator, where the series resonator includes a first Bragg reflection layer and a first piezoelectric transduction structure that are sequentially stacked on the substrate; a parallel resonator, where the parallel resonator includes a second Bragg reflection layer and a second piezoelectric transduction structure that are sequentially stacked on the substrate, and a structure of the first Bragg reflection layer is different from a structure of the second Bragg reflection layer; a series branch, where the series branch includes the series resonator, and the series branch is coupled between an input end of the filter and an output end of the filter; and a parallel branch, where the parallel branch includes the parallel resonator, and the parallel branch is coupled between the series branch and a common ground.

The filter in this embodiment of this application may be a bare chip (that is, a die), and is an integrated circuit formed on a semiconductor by using a process such as growth, doping, etching, or development. The integrated circuit includes an input end, an output end, at least one series resonator, and at least one parallel resonator, so as to implement a filtering function. It should be noted that, in a possible implementation, an exterior of the bare chip for forming the filter may be disposed in a package housing formed by a package material, and the input end, the output end, and a ground end are led out by using the package housing, so as to implement signal transmission with external components. In another possible implementation, the bare chip for forming the filter may alternatively not be packaged and disposed in a same chip with another component (for example, a capacitor or an inductor).

In this embodiment of this application, the Bragg reflection layer in the series resonator and the Bragg reflection layer in the parallel resonator are set to different thicknesses, so that transverse wave transmission coefficients of the series resonator and the parallel resonator can be changed. Therefore, a transverse wave transmission coefficient of each resonator within an effective frequency band range of the resonator is low, and reflection efficiency of each resonator is improved. That is, a quality factor Q value of the resonator is improved, and a filtering effect of the filter is further improved.

Based on the first aspect, in a possible implementation, the filter further includes a low acoustic impedance structure for forming the first Bragg reflection layer and the second Bragg reflection layer; the first Bragg reflection layer includes a first high acoustic impedance structure buried in the low acoustic impedance structure; the second Bragg reflection layer includes a second high acoustic impedance structure buried in the low acoustic impedance structure; and in a stacking direction, the first high acoustic impedance structure and the second high acoustic impedance structure have different thicknesses.

Based on the first aspect, in a possible implementation, the low acoustic impedance structure is stacked on a surface of the substrate; the filter further includes a first electrode and a thin film structure for forming the first piezoelectric transduction structure and the second piezoelectric transduction structure, where the first electrode and the thin film structure are sequentially stacked on a surface that is of the low acoustic impedance structure and that is away from the substrate; the first piezoelectric transduction structure further includes a second electrode, and the second piezoelectric transduction structure further includes a third electrode; and both the first electrode and the second electrode are disposed on a surface that is of the thin film structure and that is away from the substrate.

Based on the first aspect, in a possible implementation, in the stacking direction, the first high acoustic impedance structure includes a first surface away from the substrate, the low acoustic impedance structure includes a first surface away from the substrate, the second high acoustic impedance structure includes a first surface away from the substrate, there is a first distance between the first surface of the first high acoustic impedance structure and the first surface of the low acoustic impedance structure, there is a second distance between the first surface of the second high acoustic impedance structure and the first surface of the low acoustic impedance structure, and the first distance is different from the second distance.

The first surface of the first high acoustic impedance structure may also be referred to as an upper surface of the first high acoustic impedance structure, the first surface of the low acoustic impedance structure may also be referred to as an upper surface of the low acoustic impedance structure, and the surface of the second high acoustic impedance structure may also be referred to as an upper surface of the first high acoustic impedance structure.

Based on the first aspect, in a possible implementation, the first Bragg reflection layer further includes a third high acoustic impedance structure buried in the low acoustic impedance structure, and in the stacking direction, the third high acoustic impedance structure is disposed on a side of that is the first high acoustic impedance structure and that is away from the substrate, and the low acoustic impedance structure is disposed between the third high acoustic impedance structure and the first high acoustic impedance structure; the second Bragg reflection layer further includes a fourth high acoustic impedance structure buried in the low acoustic impedance structure, and in the stacking direction, the fourth high acoustic impedance structure is disposed on a side that is of the second high acoustic impedance structure and that is away from the substrate, and the low acoustic impedance structure is disposed between the fourth high acoustic impedance structure and the second high acoustic impedance structure; and in the stacking direction, the third high acoustic impedance structure and the fourth high acoustic impedance structure have different thicknesses.

Based on the first aspect, in a possible implementation, in the stacking direction, the first high acoustic impedance structure and the fourth high acoustic impedance structure have a same thickness; and in the stacking direction, the second high acoustic impedance structure and the third high acoustic impedance structure have a same thickness.

Based on the first aspect, in a possible implementation, the third high acoustic impedance structure includes a first surface away from the substrate, and there is a third distance between an upper surface of the first surface of the third high acoustic impedance structure and the first surface of the low acoustic impedance structure; and the fourth high acoustic impedance structure includes a first surface away from the substrate, and there is a fourth distance between the first surface of the third high acoustic impedance structure and the first surface of the low acoustic impedance structure, where the third distance is different from the fourth distance.

The first surface of the third high acoustic impedance structure may also be referred to as an upper surface of the third high acoustic impedance structure, and the first surface of the fourth high acoustic impedance structure may also be referred to as an upper surface of the fourth high acoustic impedance structure.

Based on the first aspect, in a possible implementation, the third high acoustic impedance structure includes a second surface close to the substrate, and there is a fifth distance between the second surface of the third high acoustic impedance structure and the first surface of the first high acoustic impedance structure; and the fourth high acoustic impedance structure includes a second surface close to the substrate, and there is a sixth distance between the second surface of the fourth structure and the first surface of the second high acoustic impedance structure, where the fifth distance is different from the sixth distance.

The second surface of the third high acoustic impedance structure may also be referred to as a lower surface of the third high acoustic impedance structure, and the second surface of the fourth high acoustic impedance structure may also be referred to as a lower surface of the fourth high acoustic impedance structure.

Based on the first aspect, in a possible implementation, the first high acoustic impedance structure includes a second surface close to the substrate, the low acoustic impedance structure includes a second surface close to the substrate, and there is a seventh distance between the second surface of the first high acoustic impedance structure and the second surface of the low acoustic impedance structure; and the second high acoustic impedance structure includes a second surface close to the substrate, and there is an eighth distance between the second surface of the second high acoustic impedance structure and the second surface of the low acoustic impedance structure, where the seventh distance is different from the eighth distance.

The second surface of the first high acoustic impedance structure may also be referred to as a lower surface of the first high acoustic impedance structure, the second surface of the second high acoustic impedance structure may also be referred to as a lower surface of the second high acoustic impedance structure, and the second surface of the low acoustic impedance structure may also be referred to as a lower surface of the low acoustic impedance structure.

Based on the first aspect, in a possible implementation, materials of the first high acoustic impedance structure, the second high acoustic impedance structure, the third high acoustic impedance structure, and the fourth high acoustic impedance structure include one of the following: W (tungsten), Mo (molybdenum), AlN (aluminum nitride), or Ta₂O₅ (tantalum pentoxide).

Based on the first aspect, in a possible implementation, a material of the low acoustic impedance structure includes one of the following: silicon dioxide or silicon nitride.

According to a second aspect, an embodiment of this application provides an electronic device. The electronic device includes a transceiver, and the transceiver includes the filter according to the first aspect.

Based on the second aspect, in a possible implementation, the electronic device further includes a circuit board, and the transceiver is disposed on the circuit board. In a specific implementation, the circuit board may be a printed circuit board (printed circuit board, PCB).

According to a third aspect, an embodiment of this application provides a preparation method of a filter. The preparation method includes: providing a substrate; stacking a first Bragg reflection layer and a second Bragg reflection layer on the substrate; and stacking a first piezoelectric transduction structure on the first Bragg reflection layer, and stacking a second piezoelectric transduction structure on the second Bragg reflection layer, where a structure of a first Bragg transmission layer is different from a structure of the second Bragg reflection layer.

Based on the third aspect, in a possible implementation, the stacking a first Bragg reflection layer and a second Bragg reflection layer on the substrate includes: depositing a low acoustic impedance material on the substrate to form a first low acoustic impedance layer; depositing a high acoustic impedance material on a surface of the first low acoustic impedance layer; patterning the high acoustic impedance material to form a first high acoustic impedance structure and a second high acoustic impedance structure, where the first high acoustic impedance structure and the second high acoustic impedance structure have different thicknesses in a deposition direction; and depositing a low acoustic impedance material on surfaces of the first high acoustic impedance structure and the second high acoustic impedance structure to form a second low acoustic impedance layer, where the second low acoustic impedance layer and the first low acoustic impedance layer have an integral structure to form a low acoustic impedance structure.

### BRIEF DESCRIPTION OF DRAWINGS

To describe the technical solutions in embodiments of this application more clearly, the following briefly describes the accompanying drawings required for describing embodiments of this application. Apparently, the accompanying drawings in the following descriptions show merely some embodiments of this application, and a person of ordinary skill in the art may still derive other accompanying drawings from these accompanying drawings without creative efforts.
FIG. 1 is a schematic diagram of a structure of a filter according to an embodiment of this application;
FIG. 2 is a schematic diagram of another structure of a filter according to an embodiment of this application;
FIG. 3 is a cross-sectional view of a filter according to an embodiment of this application;
FIG. 4 is another cross-sectional view of a filter according to an embodiment of this application;
FIG. 5 is a cross-sectional view of a filter in the conventional technology;
FIG. 6 is a schematic diagram of waveforms in which a transverse wave transmission coefficient and a longitudinal wave transmission coefficient of a resonator in a filter change with a frequency in the conventional technology;
FIG. 7a is a schematic diagram of waveforms in which a transverse wave transmission coefficient and a longitudinal wave transmission coefficient of a series resonator in a filter change with a frequency according to an embodiment of this application;
FIG. 7b is a schematic diagram of waveforms in which a transverse wave transmission coefficient and a longitudinal wave transmission coefficient of a parallel resonator in a filter change with a frequency according to an embodiment of this application;
FIG. 8 is another cross-sectional view of a filter according to an embodiment of this application;
FIG. 9 is another cross-sectional view of a filter according to an embodiment of this application;
FIG. 10 is another cross-sectional view of a filter according to an embodiment of this application;
FIG. 11 is a flowchart of a preparation method of a filter according to an embodiment of this application;
FIG. 12A and FIG. 12B are another flowchart of a preparation method of a filter according to an embodiment of this application;
FIG. 13a to FIG. 13k are schematic diagrams of structures in a filter preparation process according to an embodiment of this application;
FIG. 14 is a schematic diagram of a structure of an electronic device according to an embodiment of this application; and
FIG. 15 is a schematic diagram of a structure of a terminal device according to an embodiment of this application.

### DESCRIPTION OF EMBODIMENTS

The following clearly and completely describes the technical solutions in embodiments of this application with reference to the accompanying drawings in embodiments of this application. Apparently, the described embodiments are some rather than all of embodiments of this application. All other embodiments obtained by a person of ordinary skill in the art based on embodiments of this application without creative efforts shall fall within the protection scope of this application.

The "first", "second", and similar terms mentioned in this specification do not indicate any order, quantity, or significance, but are used for only distinguishing different components. Similarly, "one", "a", and similar terms also do not indicate a quantity limitation, but indicate that there is at least one. The "connection", "connected", and similar terms are not limited to a physical or mechanical connection, but may include an electrical connection, regardless of a direct or indirect connection, which are equivalent to coupling or communication in a broad sense.

The "module" mentioned in this specification generally means a functional structure divided based on logic. The "module" may be implemented by pure hardware, or may be implemented by a combination of software and hardware. In an implementation of this application, "and/or" describes an association relationship between associated objects, and indicates that three relationships may exist. For example, A and/or B may indicate the following three cases: Only A exists, both A and B exist, and only B exists.

The term "exemplary" or "for example" in embodiments of this application is for representing giving an example, an illustration, or a description. Any embodiment or design solution described as "exemplary" or "for example" in embodiments of this application should not be interpreted as being more preferred or advantageous than another embodiment or design solution. Exactly, use of the word "exemplary", "for example", or the like is intended to present a relative concept in a specific manner. In the descriptions of embodiments of this application, unless otherwise stated, "a plurality of" means two or more than two. For example, a plurality of processing units means two or more processing units; and a plurality of systems means two or more systems.

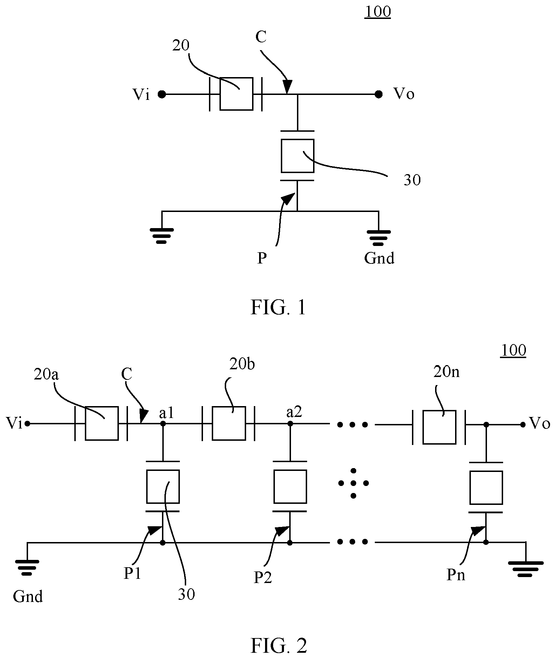

Refer to FIG. 1. FIG. 1 is a schematic diagram of a structure of a filter according to an embodiment of this application.

In FIG. 1, a filter 100 includes an input end Vi, an output end Vo, a series branch C, and a parallel branch P. One end of the series branch C is coupled to the input end Vi, and the other end is coupled to the output end Vo. One end of the parallel branch P is coupled to the series branch C, and the other end is coupled to a common ground Gnd. A series resonator 20 is disposed on the series branch C, and a parallel resonator 30 is disposed on the parallel branch P. The series branch C of the filter 100 shown in FIG. 1 is provided with the series resonator 20, and the parallel branch P is coupled between the series branch C and the common ground Gnd.

In another possible implementation, a plurality of series resonators 20a, 20b, ..., and 20n may be disposed on the series branch C. In addition, a plurality of parallel branches P1, P2, ..., and Pn may be coupled between the series branch C and the common ground Gnd. One parallel resonator 30 may be disposed on each parallel branch, or a plurality of parallel resonators 30 may be disposed on each parallel branch, which is not limited in this embodiment of this application. In a specific implementation, for one of the plurality of parallel branches P1, P2, ..., and Pn, one end of the branch may be coupled to a location between every two series resonators on the series branch C, and the other end is coupled to the common ground Gnd; or one end of the branch is coupled to the output end Vo, and the other end is coupled to the common ground Gnd. Specifically, as shown in FIG. 2, one end of the parallel branch P1 is coupled to a node a1 between the series resonator 20a and the series resonator 20b, and the other end is connected to the common ground Gnd; one end of the parallel branch P2 is coupled to a node a2 between the series resonator 20b and the series resonator 20c, and the other end is coupled to the common ground Gnd; and one end of the parallel branch Pn is coupled to the output end Vo, and the other end is coupled to the common ground Gnd. FIG. 2 schematically shows a case in which one parallel resonator 30 is disposed on each parallel branch.

It should be noted that, the filter in this embodiment of this application may be a bare chip (namely, a die), and is an integrated circuit formed on a semiconductor by using a process such as growth, doping, etching, or development. The integrated circuit includes the input end Vi, the output end Vo, at least one series resonator, and at least one parallel resonator, to implement a filtering function. It should be noted that, in a possible implementation, an exterior of the filter 100 may be disposed in a package housing formed by a package material, and the input end Vi, the output end Vo, and the ground end Gnd are led out by using the package housing, to implement signal transmission with external components. In another possible implementation, the filter 100 may alternatively not be packaged and disposed in a same chip with another component (for example, a capacitor or an inductor).

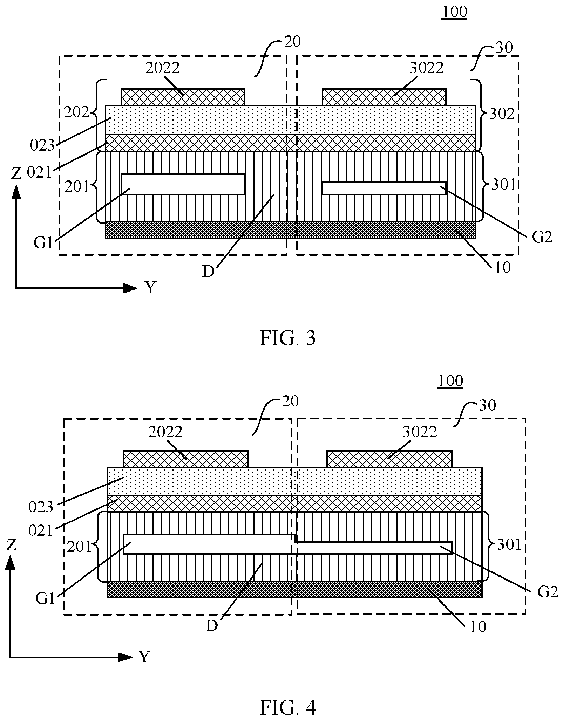

Based on the filter 100 shown in FIG. 1 and FIG. 2, the following uses an example in which the filter 100 includes one parallel branch P, one parallel resonator 30 is disposed on the parallel branch P, and one series resonator 20 is disposed on the series branch (that is, the filter 100 shown in FIG. 1 is used as an example). A specific structure of the filter 100 is described in detail with reference to FIG. 3.

Refer to FIG. 3. A cross-sectional view of the filter 100 is shown. As shown in FIG. 3, the filter 100 includes the series resonator 20 and the parallel resonator 30. The series resonator 20 and the parallel resonator 30 may share a same substrate 10. In a first direction Z, namely, a stacking direction, the series resonator 20 includes a Bragg reflection layer 201 and a piezoelectric transduction structure 202 disposed on the Bragg reflection layer 201. Similarly, in the first direction Z, the parallel resonator 30 includes a Bragg reflection layer 301 and a piezoelectric transduction structure 302 disposed on the Bragg reflection layer 301. The piezoelectric transduction structure 202 includes an electrode 021 close to the Bragg reflection layer 201, an electrode 2022 away from the Bragg reflection layer 201, and a piezoelectric thin film 023 disposed between the electrode 021 and the electrode 2022. The piezoelectric transduction structure 302 includes an electrode 021 close to the Bragg reflection layer 301, an electrode 3022 away from the Bragg reflection layer 301, and a piezoelectric thin film 023 disposed between the electrode 021 and the electrode 3022. As shown in FIG. 3, the piezoelectric transduction structure 202 and the piezoelectric transduction structure 302 share a same layer of electrode 021 and a same layer of piezoelectric thin film 023. The electrode 2022 and the electrode 3022 formed on the piezoelectric thin film 023 are separated from each other. The piezoelectric transduction structure 202 and the piezoelectric transduction structure 302 are the same as a conventional piezoelectric transduction structure, and details are not described herein again. It should be noted that, the input end Vi may be led out from the electrode 2022, the output end Vo may be led out from the electrode 023, and the ground end Gnd may be led out from the electrode 3022.

In FIG. 3, the Bragg reflection layer 201 of the series resonator 20 includes a low acoustic impedance structure D and a high acoustic impedance structure G1 buried in the low acoustic impedance structure D. Similarly, the Bragg reflection layer 301 of the parallel resonator 30 includes the low acoustic impedance structure D and a high acoustic impedance structure G2 buried in the low acoustic impedance structure D. As shown in FIG. 3, the low acoustic impedance structure D is a continuous structure that wraps the high acoustic impedance structure G1 and the high acoustic impedance structure G2. In this embodiment of this application, a material of the low acoustic impedance structure D may be a semiconductor oxide such as silicon dioxide (SiO₂). It should be noted that, the Bragg reflection layer 201 may include the high acoustic impedance structure G1 and a part that is in the low acoustic impedance structure D and that is disposed in a stacked manner with the high acoustic impedance structure G1; and the Bragg reflection layer 301 may include the high acoustic impedance structure G2 and a part that is in the low acoustic impedance structure D and that is disposed in a stacked manner with the high acoustic impedance structure G2.

It should be understood that both the low acoustic impedance structure and the high acoustic impedance structure are for a parameter of acoustic impedance. The impedance means resistance that needs to be overcome for moving a medium; and the acoustic impedance herein may be defined as "sound pressure/a speed of a medium flowing through an area", and may also be represented as "a product of a density of the medium and a speed of sound". The low acoustic impedance structure is a structure formed by a material with lower acoustic impedance, the high acoustic impedance structure is a structure formed by a material with higher acoustic impedance, and the acoustic impedance of the two structures is relative. In this embodiment of this application, a material forming the high acoustic impedance structure G1 and the high acoustic impedance structure G2 may be a metal material, for example, including but not limited to tungsten (W) and molybdenum (Mo). In addition, the material forming the high acoustic impedance structure G1 and the high acoustic impedance structure G2 may alternatively be a non-metal material, and may, for example, include but not limited to aluminum nitride (AIN) or tantalum pentoxide (Ta₂O₅). When the material forming the high acoustic impedance structure is a metal oxide, in a second direction Y, the high acoustic impedance structure G1 and the high acoustic impedance structure G2 may be discontinuous structures, namely, a structure shown in FIG. 3; and when the material forming the high acoustic impedance structure is a non-metal oxide, in the second direction Y, the high acoustic impedance structure G1 and the high acoustic impedance structure G2 may be continuous structures, namely, a structure shown in FIG. 4.

Still refer to FIG. 3 and FIG. 4. In the filter 100 shown in FIG. 3 and FIG. 4, in the first direction Z, the high acoustic impedance structure G1 in the series resonator 20 and the high acoustic impedance structure G2 in the parallel resonator 30 have different thicknesses. FIG. 3 and FIG. 4 schematically show that a thickness of the high acoustic impedance structure G1 in the series resonator 20 is greater than a thickness of the high acoustic impedance structure G2 in the parallel resonator 30. In some other possible implementations, the thickness of the high acoustic impedance structure G2 in the parallel resonator 30 may be greater than the thickness of the high acoustic impedance structure G1 in the series resonator 20. This is not limited in this embodiment of this application.

It should be noted that, the filter 100 in this embodiment of this application may be used in a scenario of a 3G/4G radio frequency band, or may be used in a scenario of a 5G radio frequency band. The 5G radio frequency band usually has features such as a high bandwidth and a high frequency. For example, in a BandN77 radio frequency band in a 5G communication protocol, a frequency of a passband of the BandN77 radio frequency band ranges from 3.3 GHz to 4.2 GHz, and a bandwidth thereof is 900 MHz. In the 5G radio frequency band, when a single device, such as a filter formed by a film bulk acoustic resonator, is used, filtering of the foregoing high-bandwidth 5G frequency band usually cannot be implemented. In other words, in the 5G radio frequency band, filtering of the foregoing 5G radio frequency band may be implemented in a manner of combining a film bulk acoustic resonator and an LC resonant circuit. In this implementation, a series resonator and a parallel resonator in the film bulk acoustic resonator usually need to be disposed at an edge of the passband, to implement edge filtering of the passband. The BandN77 is used as an example. The parallel resonator implements filtering at a low passband edge frequency of 3.3 GHz, the series resonator implements filtering at a high passband edge frequency of 4.2 GHz, and then the resonators operate with the LC resonant circuit to implement overall filtering at a frequency range of 3.3 GHz to 4.2 GHz, thereby implementing a high suppression rate at a passband edge. This requires that the series resonator in the film bulk acoustic resonator has high reflection performance for transverse waves and longitudinal waves near the frequency of 4.2 GHz, and also requires that the parallel resonator in the film bulk acoustic resonator has high reflection performance for transverse waves and longitudinal waves near the frequency of 3.3 GHz.

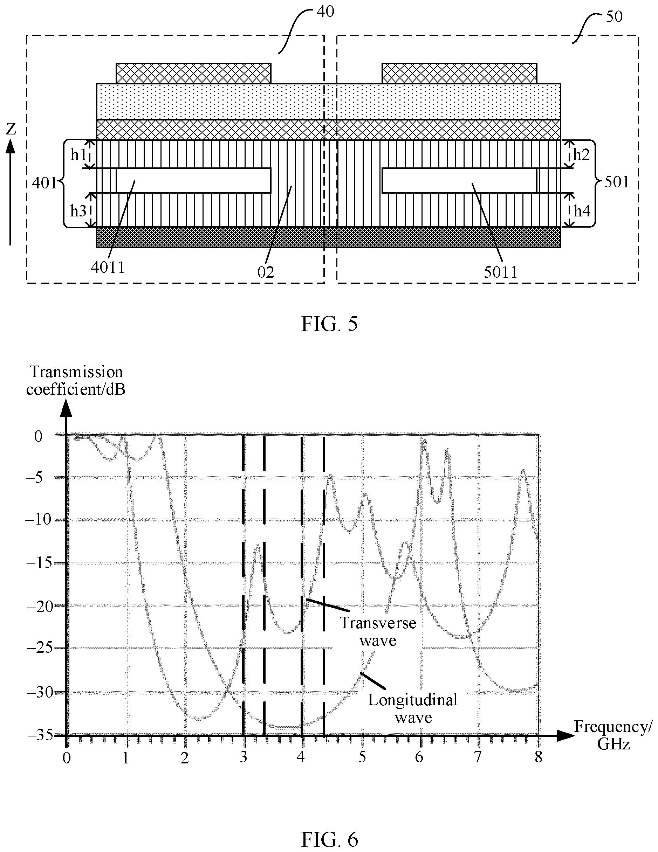

In a conventional filter, as shown in FIG. 5, a structure of a Bragg reflection layer 401 in a series resonator 40 and a structure of a Bragg reflection layer 501 in a parallel resonator 50 are the same. In other words, a high acoustic impedance structure 4011 in the series resonator 40 and a high acoustic impedance structure 5011 in the parallel resonator 50 have a same thickness in a first direction Z. In addition, a distance h1 between an upper surface of the high acoustic impedance structure 4011 in the series resonator 40 and an upper surface of a low acoustic impedance structure 02 is the same as a distance h2 between an upper surface of the high acoustic impedance structure 5011 in the parallel resonator 50 and the upper surface of the low acoustic impedance structure 02. A distance h3 between a lower surface of the high acoustic impedance structure 4011 in the series resonator 40 and a lower surface of the low acoustic impedance structure 02 is the same as a distance h4 between a lower surface of the high acoustic impedance structure 5011 in the parallel resonator 50 and the lower surface of the low acoustic impedance structure 02. When the filter formed by a film bulk acoustic resonator shown in FIG. 5 is used in a scenario of a 5G radio frequency band, based on a structure and a material characteristic of the film bulk acoustic resonator, FIG. 6 shows a schematic diagram of waveforms in which a transverse wave transmission coefficient and a longitudinal wave transmission coefficient of the series resonator 40 and the parallel resonator 50 change with a frequency. In FIG. 6, a horizontal coordinate is the frequency, and a unit is (GHz); and a vertical coordinate is the transmission coefficient, and a unit is (dB). It should be noted that, a lower transmission coefficient indicates lower acoustic wave energy leakage through a substrate and better performance of the resonator. It can be learned from FIG. 6 that, when the frequency is near 3.3 GHz, the transverse wave transmission coefficient of the parallel resonator 50 is near - 12 dB; and when the frequency is near 4.2 GHz, the transverse wave transmission coefficient of the series resonator 40 is near-17 dB. That is, in the conventional technology, both the parallel resonator 50 and the series resonator 40 have high transverse wave transmission coefficients within operating ranges thereof. When the transverse wave transmission coefficient is high, reflection efficiency of the resonator is low. That is, a value of a quality factor (quality factor, Q) of the resonator is low, and filtering effect of the filter is reduced.

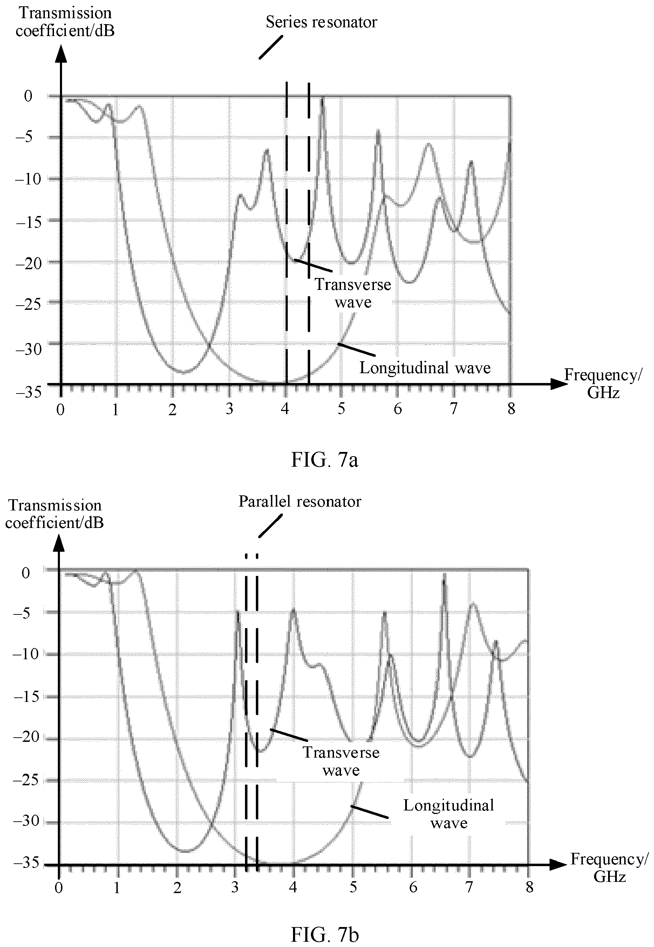

In the filter 100 shown in FIG. 3 or FIG. 4, waveforms in which the transverse wave transmission coefficient and the longitudinal wave transmission coefficient of the series resonator 20 change with the frequency are shown in FIG. 7a, and waveforms in which the transverse wave transmission coefficient and the longitudinal wave transmission coefficient of the parallel resonator 30 change with the frequency are shown in FIG. 7b. It can be learned from FIG. 7a that when the frequency is near 4.2 GHz, the transverse wave transmission coefficient of the series resonator 20 is near -20 dB; and it can be learned from FIG. 7b that when the frequency is near 3.3 GHz, the transverse wave transmission coefficient of the parallel resonator 30 is near -21 dB. Therefore, in this embodiment of this application, a transverse wave transmission coefficient of each resonator in the filter 100 is significantly reduced compared with a transverse wave transmission coefficient of each resonator in the filter shown in FIG. 5. By comparing FIG. 7a with FIG. 6 and FIG. 7b with FIG. 6, it can be learned that longitudinal wave transmission coefficients of the series resonator 20 and the parallel resonator 30 are almost the same as longitudinal wave transmission coefficients of the conventional resonators shown in FIG. 5. Therefore, in this embodiment of this application, the high acoustic impedance material layer G1 of the Bragg reflection layer 201 in the series resonator 20 and the high acoustic impedance material layer G2 of the Bragg reflection layer 302 in the parallel resonator 30 are set to different thicknesses, so that the transverse wave transmission coefficients of the series resonator 20 and the parallel resonator 30 can be changed. Therefore, a transverse wave transmission coefficient of each resonator within an effective frequency band range of the resonator is low, and reflection efficiency of each resonator is improved. That is, a quality factor Q value of the resonator is improved, and a filtering effect of the filter is further improved.

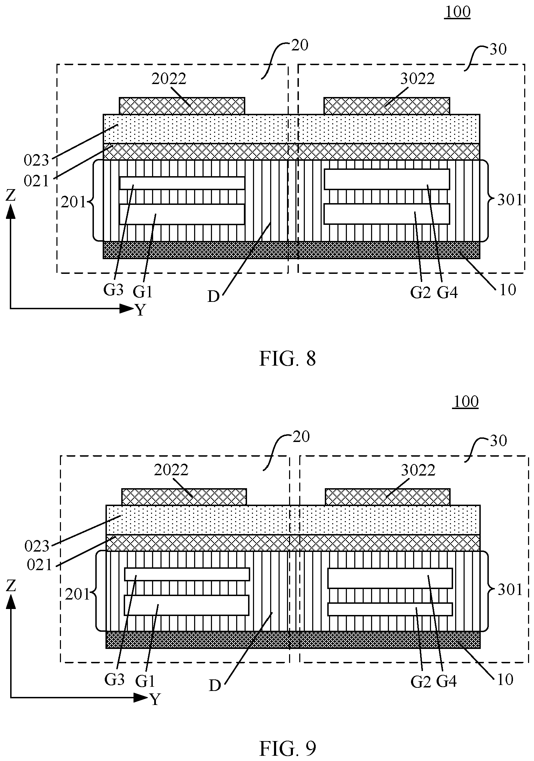

FIG. 3 and FIG. 4 schematically show that a high acoustic impedance structure is disposed in the series resonator 20 and the parallel resonator 30. In some other possible implementations, a plurality of high acoustic impedance structures, for example, two or three high acoustic impedance structures, may be disposed in both the series resonator 20 and the parallel resonator 30. Refer to FIG. 8, which is a schematic diagram in which the Bragg reflection layer 201 in the series resonator 20 and the Bragg reflection layer 301 in the parallel resonator 30 respectively include two high acoustic impedance structures.

As shown in FIG. 8, the Bragg reflection layer 201 in the series resonator 20 includes a high acoustic impedance structure G1 and a high acoustic impedance structure G3, and the Bragg reflection layer 301 in the parallel resonator 30 includes a high acoustic impedance structure G2 and a high acoustic impedance structure G4. The high acoustic impedance structure G1 and the high acoustic impedance G3 are distributed up and down in a parallel manner in FIG. 8, and the low acoustic impedance structure D is disposed between the high acoustic impedance structure G1 and the high acoustic impedance G3. In the first direction Z, the high acoustic impedance structure G1 and the high acoustic impedance G3 are parallel, and in a reverse direction of the first direction Z, sizes of the high acoustic impedance structure G1 and the high acoustic impedance G3 perpendicular to a stacking direction (that is, sizes extending in the second direction Y) gradually increase from top to bottom. In the entire resonator, the high acoustic impedance structure G3 with a smaller size is closer to a side of an electrode 021, and the high acoustic impedance structure G1 with a larger size is closer to a side of a substrate 10, so that when sound is propagated from the side of the electrode 021 to the side of the substrate 10, a waveform range gradually increases, thereby matching with a sound wave, and meeting a resonance requirement. Similarly, the high acoustic impedance structure G2 and the high acoustic impedance G4 in the Bragg reflection layer 301 are distributed up and down in a parallel manner in FIG. 8, and the low acoustic impedance structure D is disposed between the high acoustic impedance structure G2 and the high acoustic impedance G4. In the first direction Z, the high acoustic impedance structure G2 and the high acoustic impedance G4 are parallel, and in the reverse direction of the first direction Z, sizes of the high acoustic impedance structure G2 and the high acoustic impedance G4 perpendicular to the stacking direction (that is, sizes extending in the second direction Y) gradually increase from top to bottom. In FIG. 8, the high acoustic impedance structure G1 in the Bragg reflection layer 201 and the high acoustic impedance structure G2 in the Bragg reflection layer 301 have a same thickness in the first direction Z, and the high acoustic impedance structure G3 in the Bragg reflection layer 201 and the high acoustic impedance structure G4 in the Bragg reflection layer 301 have different thicknesses. Materials forming the high acoustic impedance structure G3 and the high acoustic impedance structure G4 are the same as a material forming the high acoustic impedance structure G1. For details, refer to related descriptions in FIG. 3, and details are not described herein again.

It may be understood that the Bragg reflection layer 201 in the series resonator 20 and the Bragg reflection layer 301 in the parallel resonator 30 may further include a third high acoustic impedance structure, a fourth high acoustic impedance structure, and more high acoustic impedance structures. All the high acoustic impedance structures are buried in the low acoustic impedance structure and are parallel to each other in the stacking direction, and a size of each high acoustic impedance structure extending in the second direction Y gradually increases from a direction pointing from the electrode 021 to the substrate 10. Certainly, a low acoustic impedance structure is disposed between any two high acoustic impedance structures, so that each high acoustic impedance structure and the low acoustic impedance structure are in an alternately layered structure, which facilitates sound propagation and reflection in each layer structure. When the third high acoustic impedance structure, the fourth high acoustic impedance structure, and more high acoustic impedance structures are included, a high acoustic impedance structure closest to the electrode 021 in the series resonator 20 and a high acoustic impedance structure closest to the electrode 021 in the parallel resonator 30 have different thicknesses in the first direction Z, and for any one of remaining high acoustic impedance structures in the series resonator 20, a thickness of the high acoustic impedance structure in the first direction Z is the same as that of a high acoustic impedance structure disposed at a same layer in the parallel resonator 30. The disposed at a same layer herein may be understood as: positions are the same in the Bragg reflection layers. For example, the high acoustic impedance structure G1 and the high acoustic impedance structure G2 shown in FIG. 8 may be understood as being disposed at a same layer, and the high acoustic impedance structure G3 and the high acoustic impedance structure G4 may be understood as being disposed at a same layer. When the Bragg reflection layer 201 further includes a high acoustic impedance structure G5 located between the high acoustic impedance structure G1 and the high acoustic impedance structure G3, and the Bragg reflection layer 301 further includes a high acoustic impedance structure G6 located between the high acoustic impedance structure G2 and the high acoustic impedance structure G4, the high acoustic impedance structure G5 and the high acoustic impedance structure G6 may be understood as being disposed at a same layer (not shown in the figure).

FIG. 8 schematically shows a case that both the series resonator 20 and the parallel resonator 30 in the filter 100 include two high acoustic impedance structures, and the high acoustic impedance structure G1 in the series resonator 20 that is close to the substrate 10 and the high acoustic impedance structure G2 in the parallel resonator 30 that is close to the substrate 10 have a same thickness in the first direction Z. In some other possible implementations, thicknesses of the high acoustic impedance structures disposed at a same layer of the series resonator 20 and the parallel resonator 30 are different in the first direction Z. Refer to FIG. 9, which shows a case that the high acoustic impedance structure G1 in the series resonator 20 that is close to the substrate 10 and the high acoustic impedance structure G2 in the parallel resonator 30 that is close to the substrate 10 have different thicknesses in the first direction Z. Other structures and materials used by the resonators shown in FIG. 9 are the same as structures and materials used by the resonators shown in FIG. 2, and details are not described herein again. Further, as shown in FIG. 9, a thickness of the high acoustic impedance structure G3 in the series resonator 20 that is close to the electrode 021 in the first direction Z is the same as a thickness of the high acoustic impedance structure G2 in the parallel resonator 30 that is close to the substrate 10 in the first direction Z; and a thickness of the high acoustic impedance structure G4 in the parallel resonator 30 that is close to the electrode 021 in the first direction Z is the same as a thickness of the high acoustic impedance structure G1 in the series resonator 20 that is close to the substrate 10 in the first direction Z.

In the embodiment shown in FIG. 9, in addition to setting the high acoustic impedance structure G1 and the high acoustic impedance structure G2 to different thicknesses in the first direction Z, the high acoustic impedance structure G3 and the high acoustic impedance structure G4 are also set to different thicknesses in the first direction Z. That is, thicknesses of the high acoustic impedance structures disposed at a same layer of the series resonator 20 and the parallel resonator 30 in the first direction Z are different, so that reflection efficiency of the resonator can be further improved. That is, a quality factor Q value of the resonator is further improved, and a filtering effect of the filter is improved.

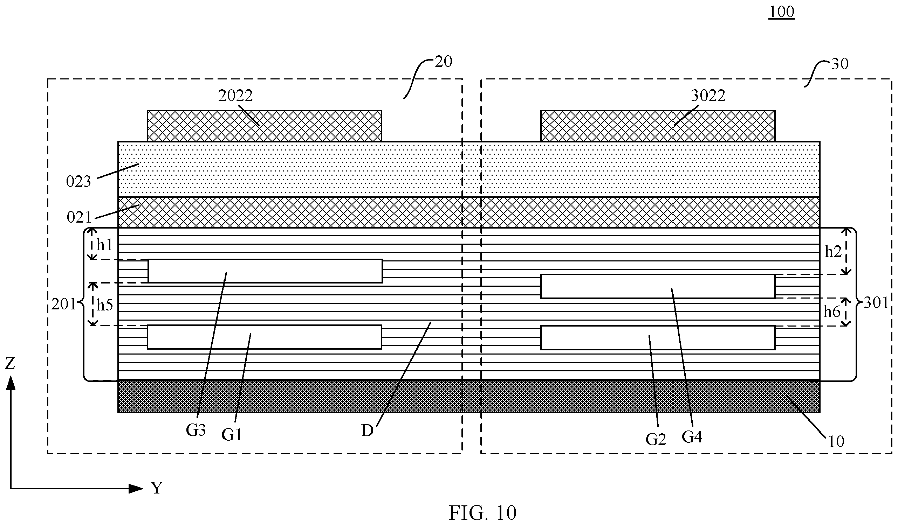

It can be learned from the embodiments shown in FIG. 2 to FIG. 9 that, in the Bragg reflection layer 201 of the series resonator 20 and the Bragg reflection layer 301 of the parallel resonator 30, at least one layer of high acoustic impedance structures disposed at a same layer has different thicknesses in the first direction Z. In some other possible implementations, high acoustic impedance structures disposed at a same layer may alternatively be set to same thickness in the first direction Z, a buried position of each high acoustic impedance structure in the series resonator 20 in the low acoustic impedance structure is adjusted, and a buried position of each high acoustic impedance structure in the parallel resonator 30 in the low acoustic impedance structure is adjusted, so that a distance between an upper surface of each high acoustic impedance structure in the series resonator 20 and an upper surface of the low acoustic impedance structure is different from a distance between an upper surface of each high acoustic impedance structure in the parallel resonator 30 and the upper surface of the low acoustic impedance structure; or a distance between a lower surface of each high acoustic impedance structure in the series resonator 20 and a lower surface of the low acoustic impedance structure is different from a distance between a lower surface of each high acoustic impedance structure in the parallel resonator 30 and the lower surface of the low acoustic impedance structure, so that transverse wave transmission coefficients of the series resonator 20 and the parallel resonator 30 can be reduced, and reflection efficiency of each resonator is improved. That is, a quality factor Q value of the resonator is improved, and a filtering effect of the filter is further improved. The following describes in detail with reference to the embodiment shown in FIG. 10.

In FIG. 10, in the filter 100 shown in FIG. 10, the Bragg reflection layer 201 of the series resonator 20 includes a high acoustic impedance structure G1 and a high acoustic impedance structure G3, where the high acoustic impedance structure G1 is disposed on a side close to the substrate 10, and the high acoustic impedance structure G3 is disposed on a side close to the electrode 021. The Bragg reflection layer 301 of the parallel resonator 30 includes a high acoustic impedance structure G2 and a high acoustic impedance structure G4, where the high acoustic impedance structure G2 is disposed on a side close to the substrate 10, and the high acoustic impedance structure G4 is disposed on a side close to the electrode 021. The high acoustic impedance structure G1 includes an upper surface close to the electrode 021 and a lower surface away from the electrode 021, and the high acoustic impedance structure G3 includes an upper surface close to the electrode 021 and a lower surface away from the electrode 021. Similarly, the high acoustic impedance structure G2 includes an upper surface close to the electrode 021 and a lower surface away from the electrode 021, and the high acoustic impedance structure G4 includes an upper surface close to the electrode 021 and a lower surface away from the electrode 021. The low acoustic impedance structure D includes an upper surface close to the electrode 021 and a lower surface close to the substrate 10. There is a first distance h1 between the upper surface of the high acoustic impedance structure G3 and the upper surface of the low acoustic impedance structure D, and there is a second distance h2 between the upper surface of the high acoustic impedance structure G3 and the upper surface of the low acoustic impedance structure D, where the first distance h1 is different from the second distance h2. There is a third distance h5 between the lower surface of the high acoustic impedance structure G3 and the upper surface of the high acoustic impedance structure G1, and there is a fourth distance h6 between the lower surface of the high acoustic impedance structure G4 and the upper surface of the high acoustic impedance structure G2, where the third distance h5 is different from the fourth distance h6.

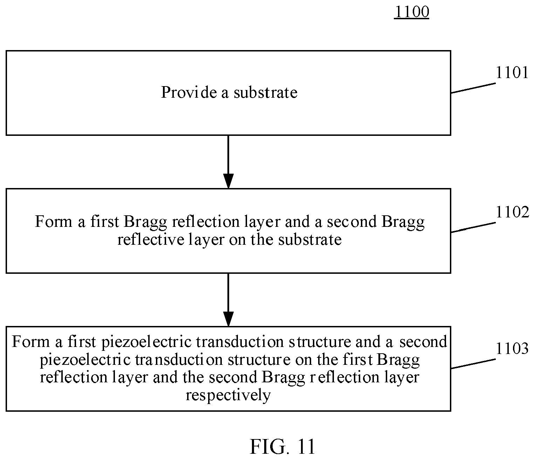

Based on the foregoing structure of each filter 100, an embodiment of this application further provides a preparation method of a filter 100. For a process procedure of preparing the filter 100, refer to the procedure 1100 shown in FIG. 11. The process procedure 1100 includes the following steps:
1101: Provide a substrate, where a material of the substrate herein may be silicon.
1102: Form a first Bragg reflection layer and a second Bragg reflective layer on the substrate, where the first Bragg reflection layer and the second Bragg reflection layer have different structures.

The first Bragg reflection layer includes a first low acoustic impedance structure and a first high acoustic impedance structure buried in the first low acoustic impedance structure, and the second Bragg reflection layer includes a second low acoustic impedance structure and a second high acoustic impedance structure buried in the second low acoustic impedance structure.

In a possible implementation, the first high acoustic impedance structure and the second high acoustic impedance structure have different thicknesses in a deposition direction.

In a possible implementation, the first Bragg reflection layer includes a first low acoustic impedance structure and a first high acoustic impedance structure and a third high acoustic impedance structure that are buried in the first low acoustic impedance structure, where the third high acoustic impedance structure is formed on the first high acoustic impedance structure and is parallel to the first high acoustic impedance structure in a stacking direction; and the second Bragg reflection layer includes a second low acoustic impedance structure and a second high acoustic impedance structure and a fourth high acoustic impedance structure that are buried in the second low acoustic impedance structure, where the fourth high acoustic impedance structure is formed on the second high acoustic impedance structure and is parallel to the second high acoustic impedance structure in the stacking direction. The first high acoustic impedance structure and the second high acoustic impedance structure have different thicknesses in a deposition direction, and the third high acoustic impedance structure and the fourth high acoustic impedance structure have different thicknesses in the deposition direction. Further, the first high acoustic impedance structure and the fourth high acoustic impedance structure have a same thickness in the deposition direction; and the second high acoustic impedance structure and the third high acoustic impedance structure have a same thickness in the deposition direction.

In a possible implementation, there is a first distance between a surface that is of the first high acoustic impedance structure and that is away from the substrate and a surface that is of the first low acoustic impedance structure and that is away from the substrate, and there is a second distance between a surface of that is the second high acoustic impedance and that is away from the substrate and a surface that is of the second low acoustic impedance structure and that is away from the substrate, where the first distance and the second distance have different lengths.

In a possible implementation, there is a third distance between a surface of the first high acoustic impedance structure that is close to the substrate and a surface of the first low acoustic impedance structure that is close to the substrate, and there is a fourth distance between a surface of the second high acoustic impedance that is close to the substrate and a surface of the second low acoustic impedance structure that is close to the substrate, where the third distance and the fourth distance have different lengths.

In a possible implementation, there is a fifth distance between a surface that is of the first high acoustic impedance structure and that is away from the substrate and a surface of the third high acoustic impedance structure that is close to the substrate, and there is a sixth distance between a surface that is of the second high acoustic impedance structure and that is away from the substrate and a surface that is of the fourth high acoustic impedance structure and that is close to the substrate, where the fifth distance and the sixth distance have different lengths.

1103: Form a first piezoelectric transduction structure and a second piezoelectric transduction structure on the first Bragg reflection layer and the second Bragg reflection layer respectively.

The first piezoelectric transduction structure includes a first piezoelectric layer close to the first Bragg reflection layer, a second piezoelectric layer away from the first Bragg reflection layer, and a thin film layer located between the first piezoelectric layer and the second piezoelectric layer; and the second piezoelectric transduction structure includes a first piezoelectric layer close to the second Bragg reflection layer, a second piezoelectric layer away from the second Bragg reflection layer, and a thin film layer located between the first piezoelectric layer and the second piezoelectric layer.

Therefore, the first Bragg reflection layer and the first piezoelectric transduction structure form a series resonator, and the second Bragg reflection layer and the second piezoelectric transduction structure form a parallel resonator.

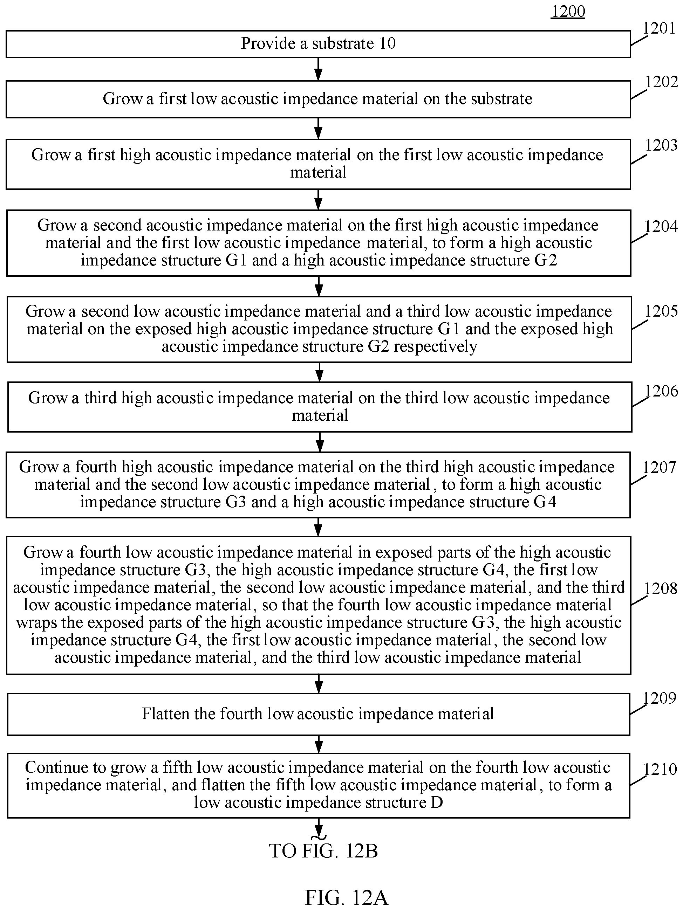

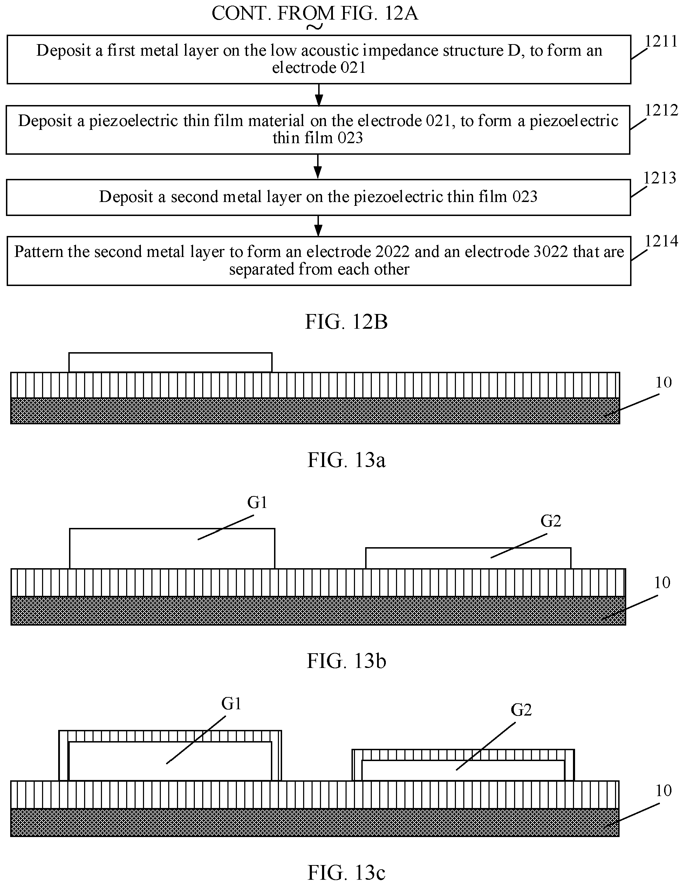

The following describes in detail the preparation method of the filter 100 by using an example of preparing the filter 100 shown in FIG. 9. For a process procedure for preparing the filter 100 shown in FIG. 9, refer to the procedure 1200 shown in FIG. 12A and FIG. 12B. The process procedure 1200 includes the following steps:
Step 1201: Provide a substrate 10, where a material of the substrate herein may be silicon.
Step 1202: Grow a first low acoustic impedance material on the substrate. The first low acoustic impedance material may be a semiconductor material, for example, SiO₂.
Step 1203: Grow a first high acoustic impedance material on the first low acoustic impedance material. This step is shown in FIG. 13a.

In a specific implementation, the first high acoustic impedance material may be a metal material, which includes but is not limited to: tungsten (W) and molybdenum (Mo).

Step 1204: Grow a second acoustic impedance material on the first high acoustic impedance material and the first low acoustic impedance material, to form a high acoustic impedance structure G1 and a high acoustic impedance structure G2.

Specifically, the second high acoustic impedance material is continuously deposited on the first high acoustic impedance material and the exposed first low acoustic impedance material, and the second high acoustic impedance material is etched, thereby forming the high acoustic impedance structure G1 and the high acoustic impedance structure G2. In a deposition direction, a thickness of the high acoustic impedance structure G1 is greater than a thickness of the high acoustic impedance structure G2, that is, an exposed upper surface of the high acoustic impedance structure G1 is higher than an upper surface of the high acoustic impedance structure G2, as shown in FIG. 13b.

The second high acoustic impedance material may be etched by using an etching method such as dry etching or wet etching.

It can be learned from step 1203 and step 1204 that the high acoustic impedance structure G1 is formed by growing the high acoustic impedance material twice. The second high acoustic impedance material may be the same as the first high acoustic impedance material.

Step 1205: Grow a second low acoustic impedance material and a third low acoustic impedance material on the exposed high acoustic impedance structure G1 and the exposed high acoustic impedance structure G2 respectively, so that the second low acoustic impedance material wraps an exposed part of the high acoustic impedance structure G1, and the third low acoustic impedance material also wraps an exposed part of the high acoustic impedance structure G2. In a stacking direction, a thickness of the second low acoustic impedance material grown on the high acoustic impedance structure G1 is the same as a thickness of the third low acoustic impedance material grown on the high acoustic impedance structure G2, as shown in FIG. 13c.

The second low acoustic impedance material and the third low acoustic impedance material may be SiO₂.

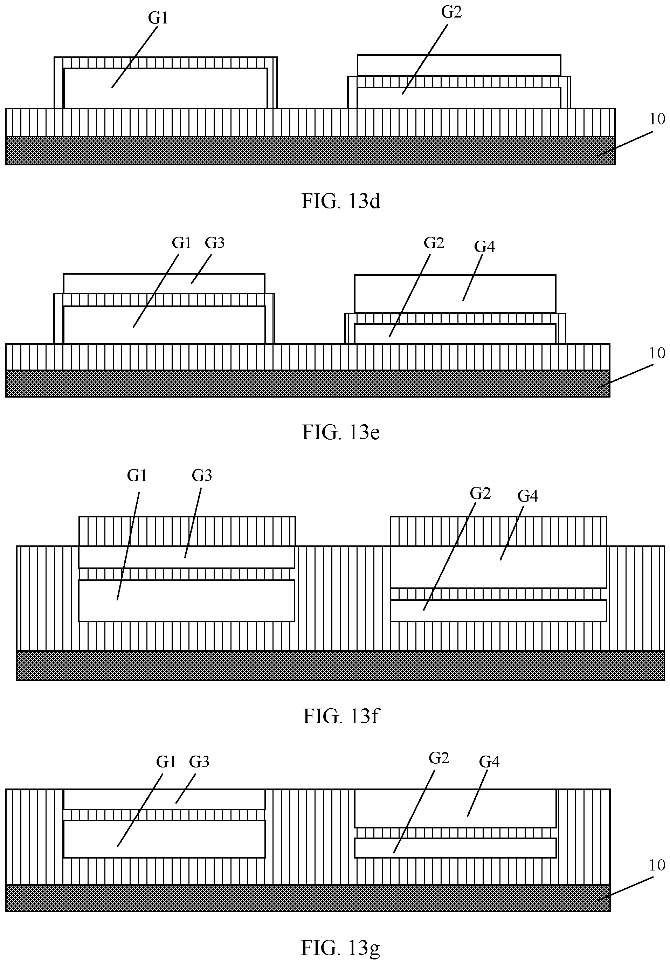

Step 1206: Grow a third high acoustic impedance material on the third low acoustic impedance material, as shown in FIG. 13d.

Step 1207: Grow a fourth high acoustic impedance material on the third high acoustic impedance material and the second low acoustic impedance material, to form a high acoustic impedance structure G3 and a high acoustic impedance structure G4, as shown in FIG. 13e.

The third high acoustic impedance material is the same as the fourth high acoustic impedance material. The third high acoustic impedance material and the fourth high acoustic impedance material may be metal materials, which include but not limited to: tungsten (W) and molybdenum (Mo).

Therefore, the fourth high acoustic impedance material grown on the second low acoustic impedance material forms the high acoustic impedance structure G3, and the third high acoustic impedance material and the fourth high acoustic impedance material grown on the third low acoustic impedance material jointly form the high acoustic impedance structure G4. In the stacking direction, a thickness of the high acoustic impedance structure G4 is greater than a thickness of the high acoustic impedance structure G3. In addition, growth amounts and etching amounts of the third high acoustic impedance material and the fourth high acoustic impedance material may be controlled, so that the thickness of the high acoustic impedance structure G3 in the stacking direction is the same as the thickness of the high acoustic impedance structure G2 in the stacking direction, and the thickness of the high acoustic impedance structure G4 in the stacking direction is the same as the thickness of the high acoustic impedance structure G1 in the stacking direction.

Step 1208: Grow a fourth low acoustic impedance material in exposed parts of the high acoustic impedance structure G3, the high acoustic impedance structure G4, the first low acoustic impedance material, the second low acoustic impedance material, and the third low acoustic impedance material, so that the fourth low acoustic impedance material wraps the exposed parts of the high acoustic impedance structure G3, the high acoustic impedance structure G4, the first low acoustic impedance material, the second low acoustic impedance material, and the third low acoustic impedance material, as shown in FIG. 13f. The fourth low acoustic impedance material may be SiO₂.

Step 1209: Flatten the fourth low acoustic impedance material.

Specifically, extra fourth low acoustic impedance material may be removed by using a chemical mechanical polishing (CMP) process, so that an exposed surface of the fourth low acoustic impedance material is flat, as shown in FIG. 13g.

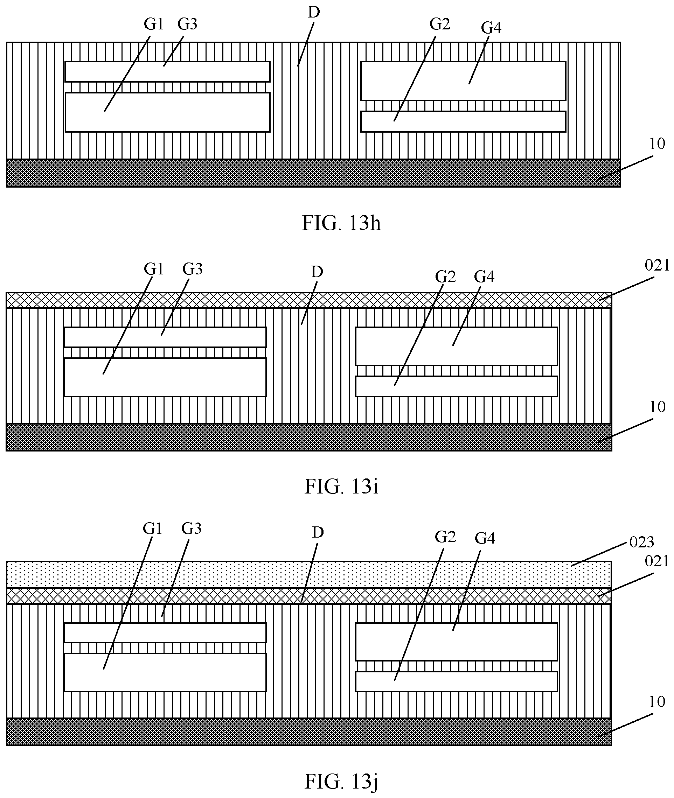

Step 1210: Continue to grow a fifth low acoustic impedance material on the fourth low acoustic impedance material, and flatten the fifth low acoustic impedance material, to form a low acoustic impedance structure D, as shown in FIG. 13h.

Specifically, extra fifth low acoustic impedance material may be removed by using a chemical mechanical polishing (CMP) process, so that an exposed surface of the fifth low acoustic impedance material is flat.

Therefore, the first low acoustic impedance material, the second low acoustic impedance material, the third low acoustic impedance material, the fourth low acoustic impedance material, and the fifth low acoustic impedance material are connected together to form a continuous low acoustic impedance structure. In addition, a Bragg reflection layer 201 is formed in a part of the continuous low acoustic impedance structure that is stacked with the high acoustic impedance structure G1 and the high acoustic impedance structure G3, and a Bragg reflection layer 301 is formed in a part of the continuous low acoustic impedance structure that is stacked with the high acoustic impedance structure G2 and the high acoustic impedance structure G4.

Step 1211: Deposit a first metal layer on the low acoustic impedance structure D, to form an electrode 021, as shown in FIG. 13i.

Step 1212: Deposit a piezoelectric thin film material on the electrode 021, to form a piezoelectric thin film 023, as shown in FIG. 13j.

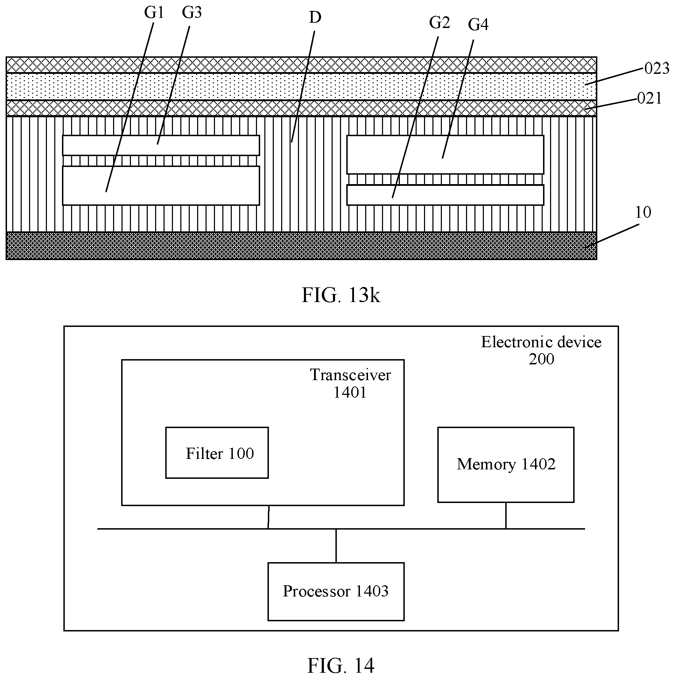

Step 1213: Deposit a second metal layer on the piezoelectric thin film 023, as shown in FIG. 13k.

Step 1214: Pattern the second metal layer to form an electrode 2022 and an electrode 3022 that are separated from each other.

In a specific process, a patterned mask layer may be formed on the second metal layer, the second metal layer is etched by using the patterned mask layer as a mask, and parts that are not etched form the electrode 2022 and the electrode 3022. Specifically, the second metal layer may be etched by using various etching methods such as dry etching or wet etching to form the electrode 2022 and the electrode 3022.

A filter prepared through step 1201 to step 1214 is shown in FIG. 9.

The electrode 2022 is disposed on the high acoustic impedance structure G1 and the high acoustic impedance structure G3, and an orthographic projection of the electrode to the high acoustic impedance structure G3 at least partially overlaps with the high acoustic impedance structure G3. The electrode 3022 is disposed on the high acoustic impedance structure G2 and the high acoustic impedance structure G4, and an orthographic projection of the electrode to the high acoustic impedance structure G4 at least partially overlaps with the high acoustic impedance structure G4. Therefore, the electrode 021, the piezoelectric thin film layer 023, and the electrode 2022 on the high acoustic impedance structure G3 jointly form a piezoelectric transduction structure 202, and the electrode 021, the piezoelectric thin film layer 023, and the electrode 3022 on the high acoustic impedance structure G4 jointly form a piezoelectric transduction structure 302. Therefore, a series resonator 20 is formed between the Bragg reflection layer 201 and the piezoelectric transduction structure 202, and a resonator 20 is formed between the Bragg reflection layer 301 and the piezoelectric transduction structure 302.

In this embodiment of this application, by using the filter manufactured by using the process steps shown in FIG. 12A and FIG. 12B, transverse wave transmission coefficients of the series resonator and the parallel resonator can be changed, so that a transverse wave transmission coefficient of each resonator within an effective frequency band range of the resonator is low, and reflection efficiency of each resonator is improved. That is, a quality factor Q value of the resonator is improved, and a filtering effect of the filter is further improved.

In a possible implementation, the process steps of forming the high acoustic impedance structure G1 and the high acoustic impedance structure G2 in step 1203 and step 1204 may be alternatively replaced with the following steps:

growing a first high acoustic impedance material and a second high acoustic impedance material on the first low acoustic impedance material, where the grown first high acoustic impedance material and the grown second high acoustic impedance material are discontinuous, and an upper surface of the first high acoustic impedance material is flush with an upper surface of the second high acoustic impedance material; and etching the second high acoustic impedance material, so that the first high acoustic impedance material forms the high acoustic impedance structure G1, and the etched second high acoustic impedance material forms the high acoustic impedance structure G2.

In addition, in a possible implementation, the process steps of forming the high acoustic impedance structure G3 and the high acoustic impedance structure G4 in step 1206 and step 1207 may be alternatively replaced with the following steps:
growing a third high acoustic impedance material on the second low acoustic impedance material, and growing a fourth high acoustic impedance material on the third low acoustic impedance material, where the grown third high acoustic impedance material and the grown fourth high acoustic impedance material are discontinuous, and a thickness of the grown third high acoustic impedance material in the stacking direction is the same as a thickness of the fourth high acoustic impedance material in the stacking direction; and etching the third high acoustic impedance material, so that the etched third high acoustic impedance material forms the high acoustic impedance structure G3, and the fourth high acoustic impedance material forms the high acoustic impedance structure G4.

An embodiment of this application further provides an electronic device 1400. Refer to FIG. 14. The electronic device 1400 may include a transceiver 1401, a memory 1402, and a processor 1403, and the foregoing filter 100 is disposed in the transceiver 1401 herein. For a structure of the filter 100, refer to one of the structures shown in FIG. 1 or FIG. 2.

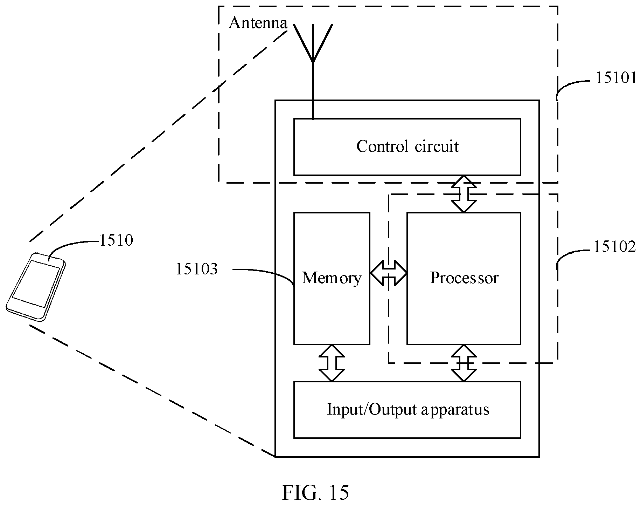

It should be understood that the electronic device 1400 herein may be specifically a terminal device such as a smartphone, a computer, or a smartwatch. An example in which the terminal device is the smartphone 1510 shown in FIG. 15 is used. The terminal device may specifically include a processor 15102, a memory 15103, a control circuit, an antenna, and an input/output apparatus. The processor 15102 is mainly configured to process a communication protocol and communication data, control the entire smartphone, execute a software program, and process data of the software program, for example, configured to support the smartphone 1510 in implementing various communication functions (for example, making a call, sending a message, or instant chatting). The memory 15103 is mainly configured to store a software program and data. The control circuit is mainly configured to convert a baseband signal and a radio frequency signal and process the radio frequency signal. The control circuit includes the filter 100. The control circuit and the antenna together may also be referred to as a transceiver 15101, and are mainly configured to receive and send a radio frequency signal in a form of an electromagnetic wave. The input/output apparatus, such as a touchscreen, a display, or a keyboard, is mainly configured to receive data input by a user and output data to the user.

After the smartphone 1510 is powered on, the processor 15102 may read the software program in the memory 15103, interpret and execute an instruction of the software program, and process data of the software program. When data needs to be sent in a wireless manner, the processor 15102 performs baseband processing on to-be-sent data, and then outputs a baseband signal to a radio frequency circuit. The radio frequency circuit performs radio frequency processing on the baseband signal, and then sends, by using the antenna, a radio frequency signal outward in a form of an electromagnetic wave. When data is sent to the smartphone 1510, the radio frequency circuit receives a radio frequency signal by using the antenna, converts the radio frequency signal into a baseband signal, and outputs the baseband signal to the processor 15102. The processor 15102 converts the baseband signal into data and processes the data.

A person skilled in the art may understand that, for ease of description, FIG. 15 shows only one memory and one processor. In an actual terminal device, there may be a plurality of processors and a plurality of memories. The memory may also be referred to as a storage medium, a storage device, or the like. It should be noted that, a type of the memory is not limited in this embodiment of this application.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A filter, comprising:
a substrate;
a series resonator, wherein the series resonator comprises a first Bragg reflection layer and a first piezoelectric transduction structure that are sequentially stacked on the substrate;
a parallel resonator, wherein the parallel resonator comprises a second Bragg reflection layer and a second piezoelectric transduction structure that are sequentially stacked on the substrate, and a structure of the first Bragg reflection layer is different from a structure of the second Bragg reflection layer;
a series branch, wherein the series branch comprises the series resonator, and the series branch is coupled between an input end of the filter and an output end of the filter; and
a parallel branch, wherein the parallel branch comprises the parallel resonator, and the parallel branch is coupled between the series branch and a common ground.

2. The filter according to claim 1, wherein
the filter further comprises a low acoustic impedance structure for forming the first Bragg reflection layer and the second Bragg reflection layer;
the first Bragg reflection layer comprises a first high acoustic impedance structure buried in the low acoustic impedance structure;
the second Bragg reflection layer comprises a second high acoustic impedance structure buried in the low acoustic impedance structure; and
in a stacking direction, the first high acoustic impedance structure and the second high acoustic impedance structure have different thicknesses.

3. The filter according to claim 2, wherein
the low acoustic impedance structure is stacked on a surface of the substrate;
the filter further comprises a first electrode and a thin film structure for forming the first piezoelectric transduction structure and the second piezoelectric transduction structure, wherein the first electrode and the thin film structure are sequentially stacked on a surface that is of the low acoustic impedance structure and that is away from the substrate;
the first piezoelectric transduction structure further comprises a second electrode, and the second piezoelectric transduction structure further comprises a third electrode; and
both the first electrode and the second electrode are disposed on a surface that is of the thin film structure and that is away from the substrate.

4. The filter according to claim 2 or 3, wherein
in the stacking direction, the first high acoustic impedance structure comprises a first surface away from the substrate, the low acoustic impedance structure comprises a first surface away from the substrate, and there is a first distance between the first surface of the first high acoustic impedance structure and the first surface of the low acoustic impedance structure; and
in the stacking direction, the second high acoustic impedance structure comprises a first surface away from the substrate, and there is a second distance between the first surface of the second high acoustic impedance structure and the first surface of the low acoustic impedance structure, wherein
the first distance is different from the second distance.

5. The filter according to any one of claims 2 to 4, wherein
the first Bragg reflection layer further comprises a third high acoustic impedance structure buried in the low acoustic impedance structure, and in the stacking direction, the third high acoustic impedance structure is disposed in parallel on a side that is of the first high acoustic impedance structure and that is away from the substrate, and the low acoustic impedance structure is disposed between the third high acoustic impedance structure and the first high acoustic impedance structure;
the second Bragg reflection layer further comprises a fourth high acoustic impedance structure buried in the low acoustic impedance structure, and in the stacking direction, the fourth high acoustic impedance structure is disposed in parallel on a side that is of the second high acoustic impedance structure and that is away from the substrate, and the low acoustic impedance structure is disposed between the fourth high acoustic impedance structure and the second high acoustic impedance structure; and
in the stacking direction, the third high acoustic impedance structure and the fourth high acoustic impedance structure have different thicknesses.

6. The filter according to claim 5, wherein
in the stacking direction, the first high acoustic impedance structure and the fourth high acoustic impedance structure have a same thickness; and
in the stacking direction, the second high acoustic impedance structure and the third high acoustic impedance structure have a same thickness.

7. The filter according to claim 5 or 6, wherein
in the stacking direction, the third high acoustic impedance structure comprises a first surface away from the substrate, the low acoustic impedance structure comprises the first surface away from the substrate, and there is a third distance between the first surface of the third high acoustic impedance structure and the first surface of the low acoustic impedance structure; and
in the stacking direction, the fourth high acoustic impedance structure comprises a first surface away from the substrate, and there is a fourth distance between the first surface of the fourth high acoustic impedance structure and the first surface of the low acoustic impedance structure, wherein
the third distance is different from the fourth distance.

8. The filter according to any one of claims 5 to 7, wherein
in the stacking direction, the third high acoustic impedance structure comprises a second surface close to the substrate, the first high acoustic impedance structure comprises the first surface away from the substrate, and there is a fifth distance between the second surface of the third high acoustic impedance structure and the first surface of the first high acoustic impedance structure; and
in the stacking direction, the fourth high acoustic impedance structure comprises a second surface close to the substrate, the second high acoustic impedance structure comprises the first surface away from the substrate, and there is a sixth distance between the second surface of the fourth high acoustic impedance structure and the first surface of the second high acoustic impedance structure, wherein
the fifth distance is different from the sixth distance.

9. The filter according to any one of claims 2 to 8, wherein
the first high acoustic impedance structure comprises a second surface close to the substrate, the low acoustic impedance structure comprises a second surface close to the substrate, and there is a seventh distance between the second surface of the first high acoustic impedance structure and the second surface of the low acoustic impedance structure; and
the second high acoustic impedance structure comprises a second surface close to the substrate, and there is an eighth distance between the second surface of the second high acoustic impedance structure and the second surface of the low acoustic impedance structure, wherein
the seventh distance is different from the eighth distance.

10. The filter according to any one of claims 2 to 9, wherein a material of the low acoustic impedance structure comprises one of the following: silicon dioxide or silicon nitride.

11. The filter according to any one of claims 5 to 8, wherein materials of the first high acoustic impedance structure, the second high acoustic impedance structure, the third high acoustic impedance structure, and the fourth high acoustic impedance structure comprise one of the following: tungsten, molybdenum, aluminum nitride, or tantalum pentoxide.

12. An electronic device, wherein the electronic device comprises a transceiver, and the transceiver comprises the filter according to any one of claims 1 to 11.

13. The electronic device according to claim 12, wherein the electronic device further comprises a circuit board, and the transceiver is disposed on the circuit board.

14. A preparation method of a filter, comprising:
providing a substrate;
stacking a first Bragg reflection layer and a second Bragg reflection layer on the substrate; and
stacking a first piezoelectric transduction structure on the first Bragg reflection layer, and stacking a second piezoelectric transduction structure on the second Bragg reflection layer, wherein
a structure of a first Bragg transmission layer is different from a structure of the second Bragg reflection layer.

15. The preparation method according to claim 14, wherein the stacking a first Bragg reflection layer and a second Bragg reflection layer on the substrate comprises:
depositing a low acoustic impedance material on the substrate to form a first low acoustic impedance layer;
depositing a high acoustic impedance material on a surface of the first low acoustic impedance layer;
patterning the high acoustic impedance material to form a first high acoustic impedance structure and a second high acoustic impedance structure, wherein the first high acoustic impedance structure and the second high acoustic impedance structure have different thicknesses in a deposition direction; and
depositing a low acoustic impedance material on surfaces of the first high acoustic impedance structure and the second high acoustic impedance structure to form a second low acoustic impedance layer, wherein the second low acoustic impedance layer and the first low acoustic impedance layer have an integral structure to form a low acoustic impedance structure.
